# EUROPEAN PATENT SPECIFICATION

(11) **EP 2 267 413 B1**
(45) Date of publication and mention of the grant of the patent: **19.10.2016**
(21) Application number: 09724570.8
(22) Date of filing: 23.03.2009
(51) Int. Cl.: G01D 5/245, G01R 33/09, H01L 43/08, B82Y 25/00, G01D 5/14

(54) **MAGNETIC SENSOR AND MAGNETIC ENCODER**
MAGNETSENSOR UND MAGNETCODIERER
DÉTECTEUR MAGNÉTIQUE ET CODEUR MAGNÉTIQUE

(30) Priority: 25.03.2008 JP 2008078344
(43) Date of publication of application: 29.12.2010
(73) Proprietor: Alps Electric Co., Ltd., Tokyo 145-8501 (JP)
(72) Inventor: ANDO, Hideto, Tokyo 145-8501 (JP); MAEKAWA, Shuji, Tokyo 145-8501 (JP); SUGIHARA, Shinji, Tokyo 145-8501 (JP); SASAKI, Shinichi, Tokyo 145-8501 (JP)
(74) Representative: Schmitt-Nilson, Gerhard
(86) International application number: PCT/JP2009/055582
(87) International publication number: WO 2009/119471

(56) References cited:
- EP-A2- 0 218 242
- WO-A1-03/046594
- WO-A1-2007/086548
- JP-A- 2 099 825
- JP-A- 2001 174 286
- JP-T- 2003 502 876
- JP-T- 2007 516 437
- JP-U- 3 036 979
- US-A1- 2008 061 775
- US-B1- 6 246 233

## Description

### Technical Field

The present invention relates to a magnetic sensor and a magnetic encoder that allow miniaturization and stabilization of output characteristics to be achieved by improving a route structure of wiring layers.

### Background Art

Magnetoresistance effect elements (GMR elements) utilizing a giant magnetoresistance effect (a GMR effect) can be used for magnetic encoders.

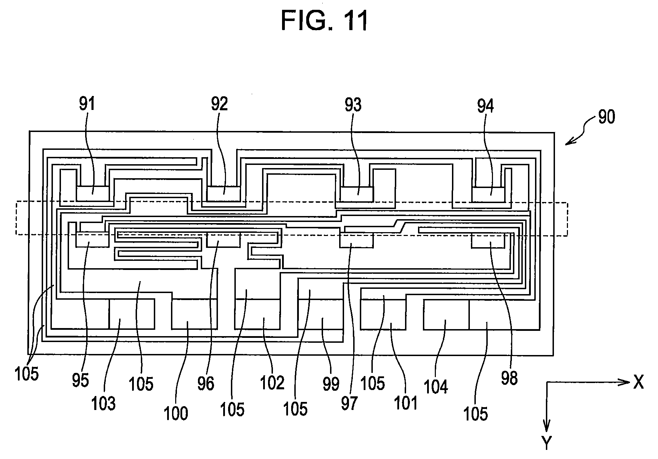

Fig. 11 is a plan view of a magnetic sensor 90 constituting a magnetic encoder in the related art. Eight magnetoresistance effect elements 91 to 98 are provided, and a bridge circuit for a phase A and a bridge circuit for a phase B are constituted by combinations of four of the magnetoresistance effect elements.

In the magnetic sensor 90 illustrated in Fig. 11, an input terminal 99 and a ground terminal 100 are terminals common to the bridge circuit for the phase A and the bridge circuit for the phase B.

Furthermore, two output terminals 101 and 102 constituting the bridge circuit for the phase A and two output terminals 103 and 104 constituting the bridge circuit for the phase B are provided.

Then, the individual magnetoresistance effect elements 91 to 98 and the individual terminals 99 to 104 are electrically connected via wiring layers 105 formed of Al or the like to configure the bridge circuit for the phase A and the bridge circuit for the phase B.
Patent Literature 1: Japanese Unexamined Patent Application Publication No. 2003-106866
Patent Literature 2: Japanese Unexamined Patent Application Publication No. 10-160511
Patent Literature 3: Japanese Unexamined Patent Application Publication No. 2003-315432
Patent Literature 4: EP0218242A2 discloses a magnetic sensor comprising magnetoresistance effect elements arranged in a matrix, having two wiring layers to minimize the size of the sensor.

### Summary of Invention

### Technical Problem

However, as described below, it is difficult to achieve miniaturization using the structure of the magnetic sensor 90 constituting the magnetic encoder of the related art, which is illustrated in Fig. 11.

In other words, the wiring layers 105 inevitably exist in spatial regions (portions that are bordered by the dotted lines illustrated in Fig. 11) existing between the magnetoresistance effect elements which are arranged in the vertical direction (the Y direction) perpendicular to a relative movement direction (the X direction). Accordingly, the distance between the magnetoresistance effect elements is increased in the vertical direction (the Y direction). In the related art illustrated in Fig. 11, the wiring layers 105 are configured using wiring with one layer. Because of routing of the wiring layers 105, it is impossible to route wiring so that the wiring layers 105 do not exist between the magnetoresistance effect elements which are arranged in the vertical direction (the Y direction).

As a result, when a relative positional relationship between the magnetoresistance effect elements and a magnet is shifted in the vertical direction (the Y direction), variations in external magnetic fields that are applied to the individual magnetoresistance effect elements and that are generated from the magnet are increased. Thus, there is a problem that the output characteristics become unstable. The problem will be more specifically described. The magnetoresistance effect element 91, the magnetoresistance effect element 95, and so forth, which are illustrated in Fig. 11, are arranged with a spacing therebetween in the vertical direction (the Y direction). When the center of the magnet is located at a position of the center between the magnetoresistance effect elements, there is no problem. However, when the magnetic sensor 90 and the magnet are shifted from each other in the vertical direction (the Y direction) due to a mechanical shift or the like, variations in an external magnetic field that flows into the magnetoresistance effect element 91 and that is provided from the magnet and an external magnetic field that flows into the magnetoresistance effect element 95 and that is provided from the magnet are increased as the spacing between the magnetoresistance effect elements 91 and 95 increases. Thus, distortion of output waveforms or the like occurs, and the output characteristics become unstable.

Furthermore, because the spacing between the magnetoresistance effect elements that oppose each other in the vertical direction (the Y direction) increases, it is impossible to increase the miniaturization of the magnetic sensor 90.

For this reason, the present invention is made to solve the above-described issues of the related art. Particularly, it is an object of the present invention to provide a magnetic sensor and a magnetic encoder that allow miniaturization and stabilization of output characteristics to be achieved by improving a route structure of wiring layers.

### Solution to Problem

The magnetic sensor according to the present invention is defined by claims 1 and 6.

A magnetic sensor according to the present invention is arranged at a position apart from a magnetized face of a magnetic-field generating member having the magnetized face on which N and S poles are alternately magnetized in a relative movement direction. The magnetic sensor includes multiple magnetoresistance effect elements that are provided on a surface of a substrate and that utilize a magnetoresistance effect in which electric resistance values change in accordance with external magnetic fields.

The magnetoresistance effect elements are arranged in a matrix form in the relative movement direction and a vertical direction that is perpendicular to the relative movement direction on the surface of the substrate.

Wiring layers are configured using lower-layer wiring and upper-layer wiring that is formed on an insulating layer covering the lower-layer wiring.

The wiring layers are routed so as not to exist in spatial regions existing between the magnetoresistance effect elements that are arranged in the vertical direction, and the multiple magnetoresistance effect elements are bridge-connected using the wiring layers.

As described above, the wiring layers have a three-dimensional configuration using the lower-layer wiring and the upper-layer wiring. The wiring layers are routed so as not to exist in the spatial regions existing between the magnetoresistance effect elements that are arranged in the vertical direction. Accordingly, the spacing between the magnetoresistance effect elements that are arranged in the vertical direction can be reduced to be shorter than that in the related art. As a result, the stabilization of output characteristics can be achieved. Furthermore, the miniaturization of the magnetic sensor can be increased.

In the present embodiment, it is preferable that the insulating layer be provided with inclined regions in which a thickness of the insulating layer gradually decreases as the insulating layer extends toward connection regions that are provided for connection of the upper-layer wiring formed on the lower-layer wiring. It is preferable that the upper-layer wiring be provided with end regions which are formed over an area extending from the inclined regions to the connection regions. It is preferable that the upper-layer wiring be electrically connected to the lower-layer wiring. Accordingly, the lower-layer wiring and the upper-layer wiring can be easily and appropriately electrically connected to each other. Furthermore, for example, the number of process steps in a production process can be reduced, compared with that in a case in which the lower-layer wiring and the upper-layer wiring are electrically connected to each other via bumps, and the magnetic sensor can be easily produced.

In the present invention, it is preferable that the lower-layer wiring be provided at a height position at which the lower-layer wiring opposes the magnetoresistance effect elements in a plane parallel to the surface of the substrate. It is preferable that the lower-layer wiring be routed in an area excluding the spatial regions existing between the magnetoresistance effect elements which are arranged in the vertical direction so that the lower-layer wiring does not exist in the spatial regions existing between the magnetoresistance effect elements which are arranged in the vertical direction. It is preferable that the upper-layer wiring be electrically connected to the lower-layer wiring via the insulating layer covering the lower-layer wiring and the magnetoresistance effect elements.

Furthermore, in the present invention, it is preferable that all of an input terminal, a ground terminal, and output terminals which are electrically connected to the magnetoresistance effect elements be arranged on the same end side along the vertical direction. It is preferable that the individual terminals be arranged in the relative movement direction. Accordingly, the miniaturization of the magnetic sensor can be increased. Moreover, using a structure in which all of the terminals are arranged on the same end side as described above, a wiring structure in which no wiring layer exists between the magnetoresistance effect elements that oppose each other in the vertical direction can be effectively realized.

Additionally, in the present invention, it is preferable that first to fourth magnetoresistance effect elements constitute a bridge circuit for a phase A. It is preferable that the first magnetoresistance effect element and the second magnetoresistance effect element be connected in series via a phase A first output terminal Va1. It is preferable that the third magnetoresistance effect element and the fourth magnetoresistance effect element be connected in series via a phase-A second output terminal Va2.

It is preferable that the first magnetoresistance effect element and the third magnetoresistance effect element be connected to each other via an input terminal. It is preferable that the second magnetoresistance effect element and the fourth magnetoresistance effect element be connected to each other via a ground terminal.

It is preferable that the first magnetoresistance effect element and the second magnetoresistance effect element, and the third magnetoresistance effect element and the fourth magnetoresistance effect element be individually arranged with predetermined center-to-center distances therebetween.

It is preferable that the first magnetoresistance effect element and the fourth magnetoresistance effect element, and the second magnetoresistance effect element and the third magnetoresistance effect element be provided side by side in the vertical direction perpendicular to the relative movement direction.

It is preferable that fifth to eighth magnetoresistance effect elements constitute a bridge circuit for a phase B. It is preferable that the fifth magnetoresistance effect element and the sixth magnetoresistance effect element be connected in series via a phase-B first output terminal Vb1. It is preferable that the seventh magnetoresistance effect element and the eighth magnetoresistance effect element be connected in series via a phase-B second output terminal Vb2.

It is preferable that the fifth magnetoresistance effect element and the seventh magnetoresistance effect element be connected to each other via the input terminal. It is preferable that the sixth magnetoresistance effect element and the eighth magnetoresistance effect element be connected to each other via the ground terminal.

It is preferable that the fifth magnetoresistance effect element and the sixth magnetoresistance effect element, and the seventh magnetoresistance effect element and the eighth magnetoresistance effect element be individually arranged with distances therebetween in the relative movement direction, and be arranged at positions that are shifted in the relative movement direction only by halves of the center-to-center distances between the individual magnetoresistance effect elements constituting the bridge circuit for the phase A.

Further, it is preferable that the fifth magnetoresistance effect element and the eighth magnetoresistance effect element, and the sixth magnetoresistance effect element and the seventh magnetoresistance effect element be provided side by side in the vertical direction perpendicular to the relative movement direction. In the present invention, this configuration can be effectively applied to the magnetic sensor provided with the bridge circuit for the phase A and the bridge circuit for the phase B that are described above.

Moreover, in the present invention, a configuration may also be used, in which fixed resistance elements are used instead of all of the second magnetoresistance effect element, the third magnetoresistance effect element, the sixth magnetoresistance effect element, and the seventh magnetoresistance effect element, and in which the fixed resistance elements are arranged in regions existing between the first magnetoresistance effect element and the fifth magnetoresistance effect element and between the fourth magnetoresistance effect element and the eighth magnetoresistance effect element.

Additionally, a magnetic encoder according to the present invention includes the magnetic sensor that has any one of the above-described configurations and the magnetic-field generating member. In the present invention, the magnetic encoder having excellent output characteristics can be provided. Furthermore, the miniaturization of the magnetic encoder can be increased.

Moreover, in the present invention, the magnetic encoder can be applied to a structure in which, when center-to-center distances between the N and S poles are set to λ, the magnetoresistance effect elements that are connected in series as pairs are arranged with center-to-center distances of λ therebetween in the relative movement direction. Alternatively, the magnetic encoder can be applied to a structure in which, when center-to-center distances between the N and S poles are set to λ, the magnetoresistance effect elements that are connected in series as pairs are arranged with center-to-center distances of λ/2 therebetween in the relative movement direction.

Furthermore, the magnetic encoder can also be applied to a structure in which, when center-to-center distances between the N and S poles are set to λ, the magnetoresistance effect elements that are adjacent to each other in the relative movement direction are arranged with center-to-center distances of λ/4 therebetween.

### Advantageous Effects of Invention

According to the present invention, the stabilization of output characteristics and the miniaturization of a magnetic sensor and a magnetic encoder can be achieved, compared with the related art.

### Description of Embodiments

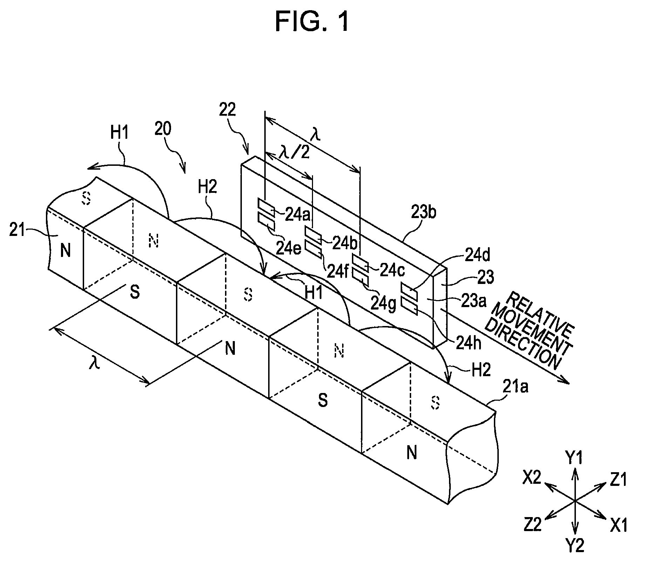

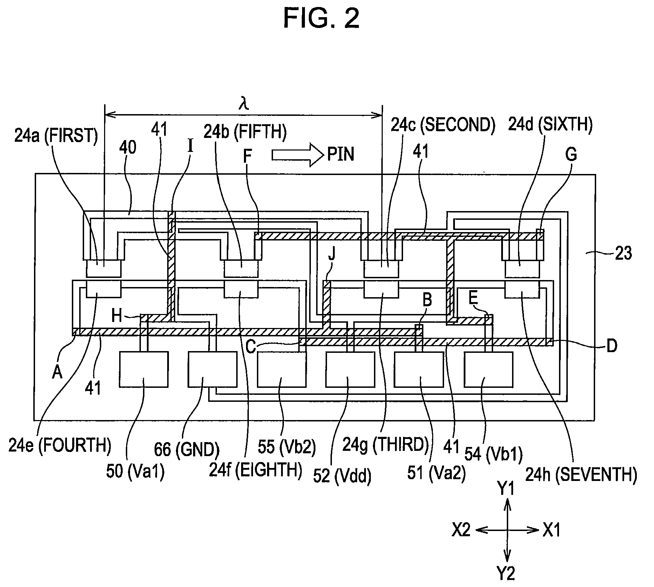

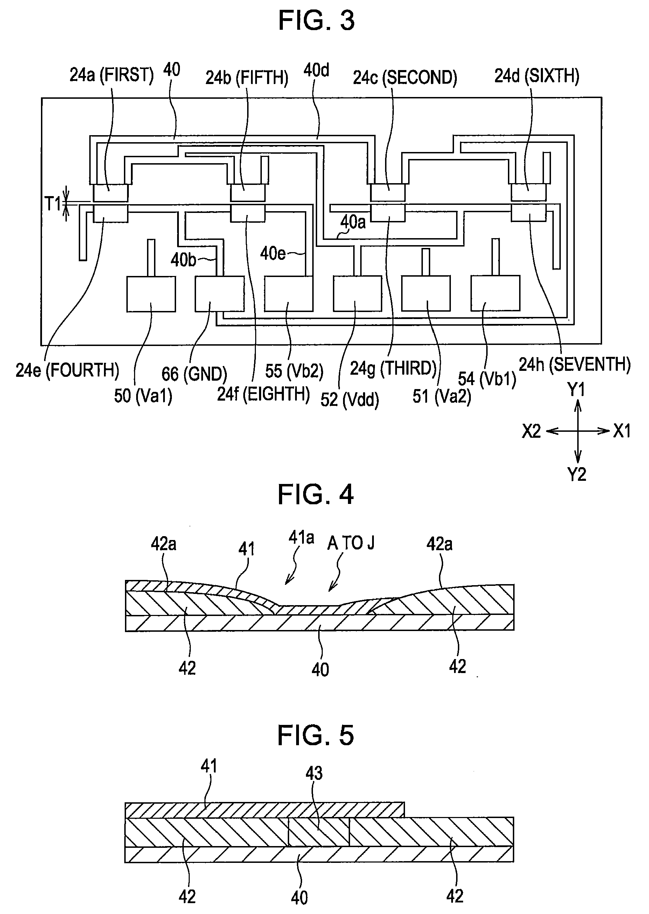

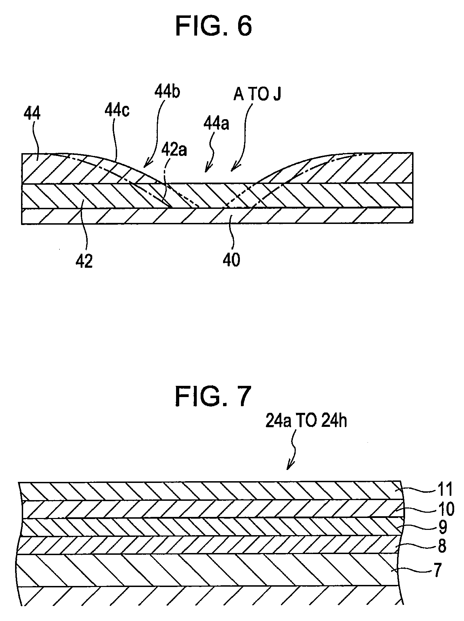

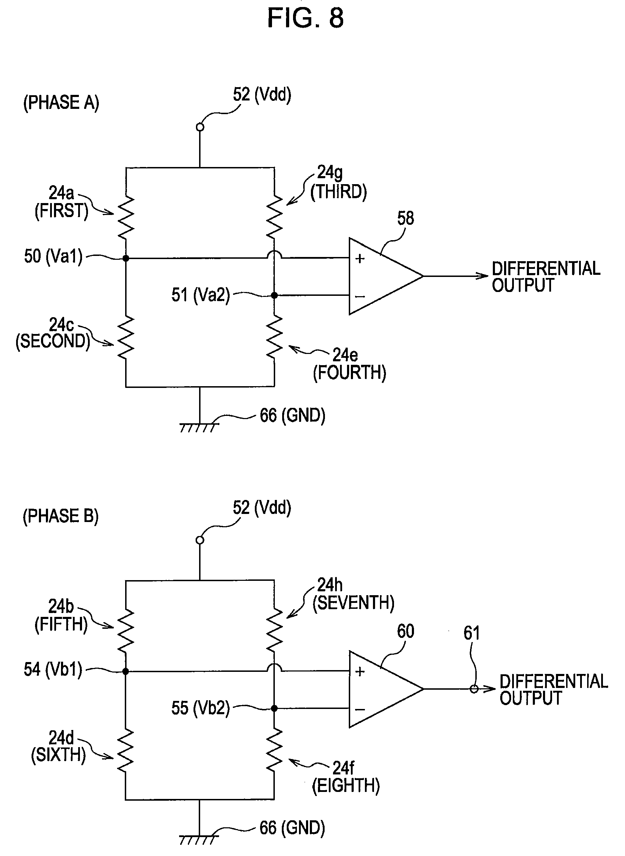

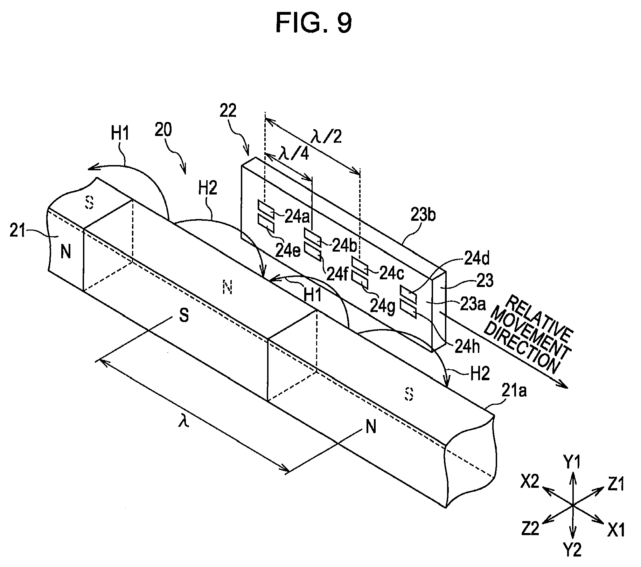

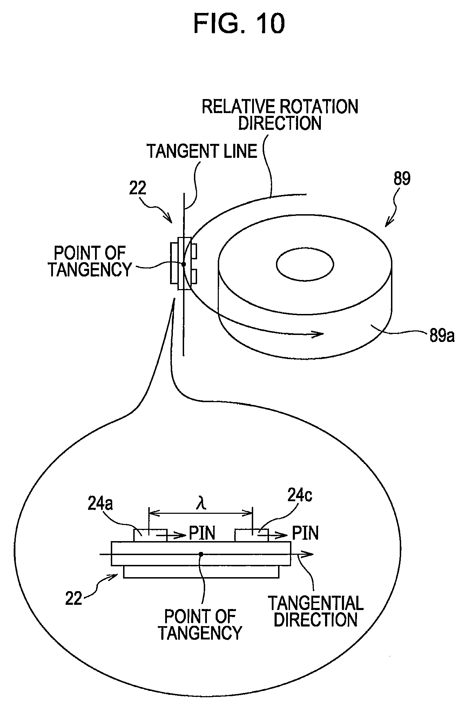

Fig. 1 is a perspective view of a magnetic encoder according to a present invention. Fig. 2 is a plan view of a magnetic sensor constituting the magnetic encoder illustrated in Fig. 1. Fig. 3 is a partial plan view of the magnetic sensor (in which upper-layer wiring is removed from Fig. 2). Figs. 4 and 5 are partial cross-sectional views illustrating connection structures between lower-layer wiring and the upper-layer wiring. Fig. 6 is a cross-sectional view illustrating a process of producing the connection structure illustrated in Fig. 4. Fig. 7 is a cross sectional view for explaining a layered structure of a magnetoresistance effect element. Fig. 8 is a circuit diagram of the magnetic sensor. Fig. 9 is a perspective view of a magnetic encoder according to the present embodiment, which is different from Fig. 1. Fig. 10 is a schematic diagram of a magnetic encoder according to the present embodiment, which is different from Fig. 1.

The X1-X2 direction, the Y1-Y2 direction, and the Z1-Z2 direction in the individual figures are interrelated in that any one of the directions is perpendicular to the remaining two directions. The X1-X2 direction is a relative movement direction determined between a magnet 21 and a magnetic sensor 22, and is the horizontal direction of a substrate 23 constituting the magnetic sensor 22. In the embodiment, a "relative movement direction" indicates the relative movement direction of a magnetic sensor unless otherwise specified. Then, in the embodiment, the relative movement direction of the magnetic sensor 22 is the X1 direction. Accordingly, when the magnet 21 is fixed and the magnetic sensor 22 moves, the magnetic sensor 22 moves in the X1 direction. When the magnetic sensor 22 is fixed and the magnet 21 moves, the magnet 21 moves in the X2 direction. Note that a formation in which both the magnet 21 and the magnetic sensor 22 move may be used. The Y1-Y2 direction is the vertical direction of the magnetic sensor 22 that is perpendicular to the relative movement direction in a plane of the substrate 23. The Z1-Z2 direction is a height direction in which the magnet 21 and the magnetic sensor 22 are arranged with a predetermined spacing therebetween so as to oppose each other.

As illustrated in Fig. 1, a magnetic encoder 20 is configured to include the magnet (magnetic-field generating member) 21 and the magnetic sensor 22.

The magnet 21 is formed in a bar shape extending in the X1-X2 direction illustrated in the figure. An opposing face of the magnet 21 that opposes the magnetic sensor 22 is a magnetized face on which N and S poles are alternately magnetized at predetermined widths in the X1-X2 direction illustrated in the figure. Center-to-center distances (pitches) between the N and S poles are Â. For example, λ ranges from 0.5 to 4.0 mm.

As illustrated in Fig. 1, the magnetic sensor 22 is configured to include the substrate 23, and multiple magnetoresistance effect elements 24a to 24h that are provided on a surface 23a of the common substrate 23 (an opposing face of the substrate 23 which opposes the magnet 21). The magnetoresistance effect elements 24a to 24h may directly be formed on the substrate 23. An insulating layer (not illustrated) may exist between the magnetoresistance effect elements 24a to 24h and the substrate 23.

As illustrated in Figs. 1 and 2, the eight magnetoresistance effect elements 24a to 24h are arranged in a matrix form in units of four in the X1-X2 direction and in units of two in the Y1-Y2 direction. As illustrated in Fig. 1, spacings between the centers of the individual magnetoresistance effect elements adjacent to each other in the X1-X2 direction are λ/2.

It is preferable that the individual magnetoresistance effect elements 24a to 24h be formed in a meander shape in which multiple element units that are formed in an elongated shape in the Y1-Y2 direction are arranged in the X1-X2 direction, and in which ends of the individual element units are connected to each other.

Each of the magnetoresistance effect elements 24a to 24h is formed in a structure in which an antiferromagnetic layer 7, a fixed magnetic layer 8, a non-magnetic layer 9, a free magnetic layer 10, and a protective layer 11 are stacked in this order from the bottom as illustrated in Fig. 7. However, the layered structure illustrated in Fig. 7 is one example. For example, the fixed magnetic layer 8 may be formed so as to have a layered ferrimagnetic structure. Furthermore, for example, the antiferromagnetic layer 7 is formed of IrMn, the fixed magnetic layer 8 is formed of CoFe, the non-magnetic layer 9 is formed of Cu, the free magnetic layer 10 is formed of NiFe, and the protective layer 11 is formed of Ta.

Each of the magnetoresistance effect elements 24a to 24h is provided with a layered portion in which at least the fixed magnetic layer 8 and the free magnetic layer 10 are stacked via the non-magnetic layer 9. An exchange coupling field (Hex) occurs between the antiferromagnetic layer 7 and the fixed magnetic layer 8, and the magnetization direction of the fixed magnetic layer 8 is oriented in one direction and fixed.

In contrast, the magnetization direction of the free magnetic layer 10 is not fixed, and the magnetization varies in accordance with an external magnetic field H.

In the present embodiment, an interface between the free magnetic layer 10 and the non-magnetic layer 9 constituting each of the magnetoresistance effect elements 24a to 24h is oriented in a face direction (the X-Y face direction) that is parallel to a magnetized face 21a of the magnet 21.

The above-described configuration is a configuration of a giant magnetoresistance effect element (a GMR element) in which the non-magnetic layer 9 is formed of Cu. However, for example, when the non-magnetic layer 9 is formed of an insulating material such as Al₂O₃ or MgO, the magnetoresistance effect elements 24a to 24h are configured as tunnel magnetoresistance effect elements (TMR elements). The magnetoresistance effect elements 24a to 24h may also be anisotropic magnetoresistance effect elements (AMR elements).

As illustrated in Fig. 3, the fixed magnetization direction (a PIN direction) of the fixed magnetic layer 8 of each of the magnetoresistance effect elements 24a to 24h is the relative movement direction (the X1 direction). The fixed magnetization direction (the PIN direction) of the fixed magnetic layer 8 may be the X2 direction.

Next, hereinafter, the magnetoresistance effect element 24a is referred to as a first magnetoresistance effect element 24a. The magnetoresistance effect element 24b is referred to as a fifth magnetoresistance effect element 24b. The magnetoresistance effect element 24c is referred to as a second magnetoresistance effect element 24c. The magnetoresistance effect element 24d is referred to as a sixth magnetoresistance effect element 24d. The magnetoresistance effect element 24e is referred to as a fourth magnetoresistance effect element 24e. The magnetoresistance effect element 24f is referred to as an eighth magnetoresistance effect element 24f. The magnetoresistance effect element 24g is referred to as a third magnetoresistance effect element 24g. The magnetoresistance effect element 24h is referred to as a seventh magnetoresistance effect element 24h.

As illustrated in Fig. 8, a bridge circuit for a phase A is constituted by the first magnetoresistance effect element 24a, the second magnetoresistance effect element 24c, the third magnetoresistance effect element 24g, and the fourth magnetoresistance effect element 24e. The first magnetoresistance effect element 24a and the second magnetoresistance effect element 24c are connected in series via a phase-A first output terminal (Va1) 50. Furthermore, the third magnetoresistance effect element 24g and the fourth magnetoresistance effect element 24e are connected in series via a phase-A second output terminal (Va2) 51. Moreover, the first magnetoresistance effect element 24a and the third magnetoresistance effect element 24g are connected to each other via an input terminal 52, and the second magnetoresistance effect element 24c and the fourth magnetoresistance effect element 24e are connected to each other via a ground terminal 66.

As illustrated in Fig. 8, the phase-A first output terminal (Va1) 50 and the phase-A second output terminal (Va2) 51 are connected to an input portion side of a first differential amplifier 58, and a differential output is obtained from the first differential amplifier 58.

Furthermore, in the present embodiment, another bridge circuit for a phase B is constituted by the fifth magnetoresistance effect element 24b, the sixth magnetoresistance effect element 24d, the seventh magnetoresistance effect element 24h, and the eighth magnetoresistance effect element 24f. The fifth magnetoresistance effect element 24b and the sixth magnetoresistance effect element 24d are connected in series via a phase-B first output terminal (Vb1) 54. The seventh magnetoresistance effect element 24h and the eighth magnetoresistance effect element 24f are connected in series via a phase-B second output terminal (Vb2) 55. Moreover, as illustrated in Fig. 8, the fifth magnetoresistance effect element 24b and the seventh magnetoresistance effect element 24h are connected to each other via the input terminal 52, and the sixth magnetoresistance effect element 24d and the eighth magnetoresistance effect element 24f are connected to each other via the ground terminal 66.

As illustrated in Fig. 8, the phase-B first output terminal (Vb1) 54 and the phase-B second output terminal (Vb2) 55 are connected to an input portion side of a second differential amplifier 60, and a differential output is obtained from the second differential amplifier 60.

As illustrated in Fig. 1, spacings between the centers of the magnetoresistance effect elements that are connected in series in the bridge circuits illustrated in Fig. 8 are λ.

Note that the input terminal 52 and the ground terminal 66 are terminals common to the phases A and B.

When the magnetic sensor 22 relatively moves in the X1 direction with respect to the magnet 21, external magnetic fields H1 and H2 enter the individual magnetoresistance effect elements 24a to 24h from the magnetized face 21a of the magnet 21. As illustrated in Fig. 1, the direction of the external magnetic fields H1 and the direction of the external magnetic fields H2 are different from each other. Furthermore, when the magnetoresistance effect elements are positioned exactly above the magnetic poles, regarding magnetic-field elements for the magnetoresistance effect elements, perpendicular magnetic fields become predominant, and the magnetoresistance effect elements enter a state (no-magnetic-field state) in which external magnetic fields are zero.

Here, as a typical state, a state will be described, in which external magnetic fields enter the first magnetoresistance effect element 24a and the second magnetoresistance effect element 24c that constitute the bridge circuit for the phase A and that are connected in series.

Because the first magnetoresistance effect element 24a and the second magnetoresistance effect element 24c are λ distant from each other in the relative movement direction (the X1 direction), when the external magnetic field H1 enters the first magnetoresistance effect element 24a, the external magnetic field H2 enters the second magnetoresistance effect element 24c. In this case, because the fixed magnetization direction (the P direction) of the fixed magnetic layer 8 is the X1 direction, the resistance value of the first magnetoresistance effect element 24a increases due to the entry of the external magnetic field H1. In contrast, the resistance value of the second magnetoresistance effect element 24c decreases due to the entry of the external magnetic field H2. Furthermore, when the magnetic sensor 22 relatively moves only by λ/2 in the X1 direction, the resistance values of the first magnetoresistance effect element 24a and the second magnetoresistance effect element 24c do not change because perpendicular magnetic fields enter the first magnetoresistance effect element 24a and the second magnetoresistance effect element 24c. Further, when the magnetic sensor 22 relatively moves only by λ/2 in the X1 direction, the external magnetic field H2 enters the first magnetoresistance effect element 24a, and the external magnetic field H1 enters the second magnetoresistance effect element 24c. Accordingly, the resistance value of the first magnetoresistance effect element 24a decreases, and the resistance value of the second magnetoresistance effect element 24c increases.

Although output waveforms of, for example, substantially rectangular waves are obtained from the bridge circuit for the phase A and the bridge circuit for the phase B that are illustrated in Fig. 8, the output waveforms are output so that the output waveforms have a phase shift corresponding to λ/2 therebetween. The movement velocity or movement distance of the magnetic sensor 22 or magnet 21 can be detected on the basis of the output waveforms. Furthermore, because two systems, i.e., the phase A and the phase B, are used, the direction of the phase shift of the output waveform obtained from the bridge circuit for the phase B from the output waveform obtained from the bridge circuit for the phase A is detected, whereby the movement direction can be recognized.

The arrangement of the magnetoresistance effect elements 24a to 24h will be described. The arrangement will be described using Fig. 2. In the bridge circuit for the phase A, the first magnetoresistance effect element 24a and the second magnetoresistance effect element 24c, and the third magnetoresistance effect element 24g and the fourth magnetoresistance effect element 24e, which are connected in series, are individually arranged with spacings of λ therebetween in the relative movement direction (the X1 direction).

Furthermore, the first magnetoresistance effect element 24a and the fourth magnetoresistance effect element 24e, and the second magnetoresistance effect element 24c and the third magnetoresistance effect element 24g are provided side by side in the vertical direction (the Y1-Y2 direction).

In the embodiment illustrated in Fig. 2, individually, the first magnetoresistance effect element 24a is arranged on the Y1 side along the X2 direction, the second magnetoresistance effect element 24c is arranged on the Y1 side along the X1 direction, the third magnetoresistance effect element 24g is arranged on the Y2 side along the X1 direction, and the fourth magnetoresistance effect element 24e is arranged on the Y2 side along the X2 direction.

Next, in the bridge circuit for the phase B, the fifth magnetoresistance effect element 24b and the sixth magnetoresistance effect element 24d, and the seventh magnetoresistance effect element 24h and the eighth magnetoresistance effect element 24f, which are connected in series, are individually arranged with spacings of λ therebetween in the relative movement direction (the X1 direction), and are arranged at positions that are shifted only by λ/2 in the relative movement direction (the X1 direction) from the positions of the individual magnetoresistance effect elements constituting the bridge circuit for the phase A.

Furthermore, the fifth magnetoresistance effect element 24b and the eighth magnetoresistance effect element 24f, and the sixth magnetoresistance effect element 24d and the seventh magnetoresistance effect element 24h are provided side by side in the vertical direction (the Y1-Y2 direction).

In the embodiment illustrated in Fig. 2, individually, the fifth magnetoresistance effect element 24b is arranged between the first magnetoresistance effect element 24a and the second magnetoresistance effect element 24c, the sixth magnetoresistance effect element 24d is arranged closer to the X1 side than the second magnetoresistance effect element 24c, the seventh magnetoresistance effect element 24h is arranged closer to the X1 side than the third magnetoresistance effect element 24g, and the eighth magnetoresistance effect element 24f is arranged between the fourth magnetoresistance effect element 24e and the third magnetoresistance effect element 24g.

Next, as illustrated in Fig. 2, all of the input terminal 52, the ground terminal 66, the phase-A first output terminal 50, the phase-A second output terminal 51, the phase-B first output terminal 54, and the phase-B second output terminal 55 are arranged on an end of the Y2 side of the substrate 23, and arranged at spacings in the X1-X2 direction.

In the present embodiment, wiring layers that electrically connect between the individual magnetoresistance effect elements 24a to 24h and between the individual magnetoresistance effect elements 24a to 24h and the individual terminals have a three-dimensional configuration using lower-layer wiring 40 and upper-layer wiring 41. The wiring layers are formed of Al or the like. In Fig. 2, both the lower-layer wiring 40 and the upper-layer wiring 41 are illustrated, and, in Fig. 3, only the lower-layer wiring 40 is illustrated. Because an insulating layer 42 exists between the lower-layer wiring 40 and the upper-layer wiring 41, it is impossible in reality to view both the upper-layer wiring 41 and the lower-layer wiring 40 in planar view. However, in Fig. 2, both the lower-layer wiring 40 and the upper-layer wiring 41 are illustrated in a state in which the insulating layer 42 is removed. Furthermore, in Fig. 2, the upper-layer wiring 41 is illustrated using diagonal lines.

First, the lower-layer wiring 40 will be described. The lower-layer wiring 40 is formed at a height position at which the lower-layer wiring 40 opposes the individual magnetoresistance effect elements 24a to 24h in a plane (an X-Y plane) parallel to the surface of the substrate. For example, the lower-layer wiring 40 is formed on a plane that is the same as a plane on which the individual magnetoresistance effect elements 24a to 24h are formed. Although the lower-layer wiring 40 is not necessarily formed on the same plane, the lower-layer wiring 40 can be easily formed by forming the lower-layer wiring 40 on the same plane.

As illustrated in Fig. 3, the lower-layer wiring 40 is provided with an input wiring layer 40a that connects between the input terminal 55 and the first magnetoresistance effect element 24a, the fifth magnetoresistance effect element 24b, the third magnetoresistance effect element 24g, and the seventh magnetoresistance effect element 24h. Furthermore, the lower-layer wiring 40 is provided with ground wiring layers 40b and 40c that connect between the ground terminal 66 and the second magnetoresistance effect element 24c, the sixth magnetoresistance effect element 24d, the fourth magnetoresistance effect element 24e, and the eighth magnetoresistance effect element 24f. Moreover, the lower-layer wiring 40 is provided with a connection wiring layer 40d that connects between the first magnetoresistance effect element 24a and the second magnetoresistance effect element 24c, and a connection wiring layer 40e that connects between the phase-B second output terminal 55 and the eighth magnetoresistance effect element 24f. In addition, in the lower-layer wiring 40, connection wiring layers that extend partway from ends of the fifth magnetoresistance effect element 24b, the sixth magnetoresistance effect element 24d, the fourth magnetoresistance effect element 24e, the third magnetoresistance effect element 24g, and the seventh magnetoresistance effect element 24h and from the output terminals 50, 52, and 54 are provided.

As illustrated in Fig. 3, the lower-layer wiring 40 is not formed in spatial regions existing between the magnetoresistance effect elements that are arranged in the vertical direction (the Y direction).

The upper-layer wiring 41 is formed via the insulating layer 42 on the lower-layer wiring 40, on the magnetoresistance effect elements 24a to 24h, and on the surface of the substrate that extends to the peripheries of the lower-layer wiring 40 and the magnetoresistance effect elements 24a to 24h.

The upper-layer wiring 41 is electrically connected to the lower-layer wiring 40 at positions of individual connection regions A to J illustrated in Fig. 2. As illustrated in Fig. 4, the insulating layer 42 formed on the lower-layer wiring 40 is provided with inclined regions 42a in which the thickness of the insulating layer 42 gradually decreases as the insulating layer 42 extends toward the connection regions A to J. Then, the upper-layer wiring 41 is provided with end regions 41a that are formed over an area extending from the inclined regions 42a of the insulating layer 42 to the lower-layer wiring 40 in the connection regions A to J.

Using the connection structure of the lower-layer wiring 40 and the upper-layer wiring 41 illustrated in Fig. 4, the lower-layer wiring 40 and the upper-layer wiring 41 can be simply and appropriately electrically connected to each other. Furthermore, in a formation illustrated in Fig. 5, the lower-layer wiring 40 and the upper-layer wiring 41 are electrically connected to each other via bump units 43. Although the connection structure illustrated in Fig. 5 is also a form of the present embodiment, in Fig. 5, a process of forming the bump units 43 and a process of planarizing the surface of the insulating layer 42 are necessary. In contrast, in the formation illustrated in Fig. 4, these processes are unnecessary. A process of producing the formation illustrated in Fig. 4 will be described using Fig. 6.

As illustrated in Fig. 6, the insulating layer 42 is formed all over the lower-layer wiring 40, over the magnetoresistance effect elements 24a to 24h, and over the surface of the substrate that extends to the peripheries of the lower-layer wiring 40 and the magnetoresistance effect elements 24a to 24h. Next, a process of planarizing the surface of the insulating layer 42 using a CMP technology or the like is performed. Next, a resist layer 44 is provided on the insulating layer 42. In the resist layer 44, spacings 44a are provided in portions of the resist layer 44 corresponding to the connection regions A to J. Furthermore, the resist layer 44 is subjected to heat treatment, thereby generating loose portions at ends 44b of the resist layer 44, so that inclined faces 44c are generated. Then, the insulating layer 42 is subjected to an etching process. Accordingly, the insulating layer 42 that is not covered with the resist layer 44 is removed. Moreover, in the etching process, one portion of the resist layer 44 is also trimmed (alternate long and short dash line), and, in association with that, the ends of the insulating layer 42 are also trimmed so as to be formed as inclined faces, so that the inclined regions 42a which are described with reference to Fig. 4 is completed. After that, the resist layer 44 is removed.

Then, the upper-layer wiring 41 is formed in a route shape, which is illustrated in Fig. 2, on the insulating layer 42. In this case, as illustrated in Fig. 4, the end regions 41a of the upper-layer wiring 41 are formed over an area extending from the inclined regions 42a of the insulating layer 42 to the lower-layer wiring 40 in the connection regions A to J. Even when the bump units 43 as illustrated in Fig. 5 do not exist, the upper-layer wiring 41 can be appropriately and easily formed over an area extending from the inclined regions 42a of the insulating layer 42 to the lower-layer wiring 40 in the connection regions A to J.

As illustrated in Fig. 2, the lower-layer wiring 40 and the upper-layer wiring 41 are routed so as to have a three-dimensional configuration, whereby the magnetoresistance effect elements 24a to 24h are bridge-connected.

In the distinctive configuration in the present embodiment, the wiring layers are configured using the lower-layer wiring 40 and the upper-layer wiring 41 that are formed on the insulating layer 42 covering the lower-layer wiring 40. The wiring layers are routed so as not to exist in the spatial regions existing between the magnetoresistance effect elements which are arranged in the vertical direction (the Y direction). Here, the "spatial regions existing between the magnetoresistance effect elements" indicate regions that are unoccupied between the magnetoresistance effect elements which are arranged in the vertical direction (the Y1-Y2 direction) in the range of the thickness of the magnetoresistance effect elements.

In the present embodiment, all of the lower-layer wiring 40 and the upper-layer wiring 41 are routed so as not to exist in the spatial regions existing between the magnetoresistance effect elements which are arranged in the vertical direction (the Y direction). Accordingly, a spacing T1 between the magnetoresistance effect elements arranged in the vertical direction (the Y direction) can be effectively reduced to be shorter than that in the related art. Specifically, the magnetoresistance effect elements can be formed with the spacing T1, therebetween, that ranges from 0 to 200 µm (however, 0 µm is not included).

In the embodiment illustrated in Fig. 3, the lower-layer wiring 40 is formed, for example, on the same plane on which the magnetoresistance effect elements 24a to 24h are formed. However, as illustrated in Fig. 3, the lower-layer wiring 40 is routed so as not to be formed in the spacing between the magnetoresistance effect elements arranged in the vertical direction (the Y1-Y2 direction). In contrast, when the upper-layer wiring 41 that is formed via the insulating layer 42 on the lower-layer wiring 40 is positioned in a region which is provided above the magnetoresistance effect elements 24a to 24h so that the upper-layer wiring 41 is apart from the magnetoresistance effect elements 24a to 24h, the upper-layer wiring 41 can be comparatively freely routed. For example, the upper-layer wiring 41 may be routed so that a portion of the upper-layer wiring 41 is positioned between the magnetoresistance effect elements arranged in the vertical direction (the Y1-Y2 direction) in planar view.

Note that the formation of routing of the wiring layers is not limited to the formation illustrated in Fig. 2. For example, the route structure of the upper-layer wiring illustrated in Fig. 2 is used for lower-layer wiring that is formed in a region which is provided below the magnetoresistance effect elements 24a to 24h. Upper-layer wiring may be formed with a route structure that is the same as the route structure of the lower-layer wiring illustrated in Figs. 2 and 3.

As described above, in the present embodiment, the spacing between the magnetoresistance effect elements that are arranged in the vertical direction (the Y1-Y2 direction) can be reduced to be shorter than that in the related art. Accordingly, even when the magnetic sensor 22 and the magnet 21 are slightly shifted from each other in the vertical direction (the Y1-Y2 direction) due to a mechanical shift or the like, variations in the external magnetic fields that flow into the magnetoresistance effect elements which oppose each other in the vertical direction (the Y1-Y2 direction) can be reduced to be smaller than those in the related art. Accordingly, the variations in the output waveforms can be reduced, and stabilization of the output characteristics can be achieved. Furthermore, because the spacing between the magnetoresistance effect elements that are arranged in the vertical direction (the Y1-Y2 direction) can be reduced, miniaturization of the magnetic sensor 22 can be achieved.

The present embodiment can be effectively applied to a formation in which the eight magnetoresistance effect elements 24a to 24h constituting the phases A and B are arranged in a matrix form on the surface 23a of the substrate particularly as illustrated in Figs. 2 and 8.

Furthermore, as illustrated in Fig. 2, all of the input terminal 52, the ground terminal 66, the output terminals 50, 51, 54, and 54 are arranged on one end side of the magnetic sensor 22 along the vertical direction (the Y1-Y2 direction), and arranged in the horizontal direction (the X1-X2 direction). Accordingly, the dimension of the magnetic sensor 22 in the vertical direction can be reduced, and the miniaturization of the magnetic sensor 22 can be increased. In addition, in a formation in which the individual terminals are arranged on one end side as described above, wiring can be effectively performed so that the wiring layers do not exist in the spatial regions existing between the magnetoresistance effect elements which oppose each other in the vertical direction (the Y1-Y2 direction).

The configuration of the magnetic encoder 20 using the above-described magnetic sensor 22 is a configuration called a low-frequency encoder. In the low-frequency encoder, fixed resistance elements are used instead of all of the second magnetoresistance effect element 24c, the third magnetoresistance effect element 24g, the sixth magnetoresistance effect element 24d, and the seventh magnetoresistance effect element 24h. A configuration may also be used, in which the fixed resistance elements are caused to exist between the first magnetoresistance effect element 24a and the fifth magnetoresistance effect element 24b and between the fourth magnetoresistance effect element 24e and the eighth magnetoresistance effect element 24f. Accordingly, the miniaturization of the magnetic sensor 22 can further be increased.

Alternatively, a configuration of a harmonics-frequency encoder may also be used, in which the center-to-center distances between the magnetoresistance effect elements that are illustrated in Fig. 2 and that are connected in series are set to λ/2, and in which the magnetization direction (the PIN direction) of the fixed magnetic layer of each of the magnetoresistance effect elements is oriented to a direction perpendicular to the relative movement direction (the X1-Y2 direction). In the harmonics-frequency encoder, center-to-center distances between the magnetoresistance effect elements that are adjacent each other in the relative movement direction are λ/4.

The magnetic encoder 20 according to the present embodiment is an encoder in which the magnetic sensor 22 linearly relatively moves with respect to the magnet 21 as illustrated in Fig. 1. However, as illustrated in Fig. 10, the magnetic encoder 20 according to the present embodiment may be a rotary magnetic encoder that has a rotating drum 89 having a surface 89a on which N and S poles are alternately magnetized and the magnetic sensor 22, and that can detect a rotational velocity, the number of rotations, and a rotation direction using outputs which are obtained by rotation of the rotating drum 89.

As illustrated in an enlarged view of Fig. 10, when center-to-center distances (pitches) between the N and S poles are set to λ as in the case of the magnetic encoder that is illustrated in Fig. 1 and that linearly moves, the center-to-center distances between the individual magnetoresistance effect elements that are connected in series are controlled so that the center-to-center distances are set to, for example, λ. In Fig. 10, as typical magnetoresistance effect elements, the first magnetoresistance effect element 24a and the second magnetoresistance effect element 24c that are connected in series are illustrated.

As illustrated in Fig. 10, the fixed magnetization direction (the PIN direction) of the fixed magnetic layer 8 of each of the magnetoresistance effect elements 24a to 24h is fixed to, for example, a direction that is parallel to a tangential direction (the relative movement direction of the magnetic sensor 22) which is determined when the center of the substrate 23 of the magnetic sensor 22 is considered as a point of tangency along a relative rotation direction of the magnetic sensor 22.

### Brief Description of Drawings

[Fig. 1] Fig. 1 is a perspective view of a magnetic encoder according to a present invention.
[Fig. 2] Fig. 2 is a plan view of a magnetic sensor constituting the magnetic encoder illustrated in Fig. 1 (however, in which an insulating layer between lower-layer wiring and upper-layer wiring is removed).
[Fig. 3] Fig. 3 is a partial plan view of the magnetic sensor (however, in which the upper-layer wiring is removed from Fig. 2).
[Fig. 4] Fig. 4 is a partial cross-sectional view illustrating a connection structure between the lower-layer wiring and the upper-layer wiring (a cross-sectional view in which the connection structure is cut along a thickness direction).
[Fig. 5] Fig. 5 is a partial cross-sectional view illustrating a connection structure between lower-layer wiring and upper-layer wiring (a cross-sectional view in which the connection structure is cut along a thickness direction).
[Fig. 6] Fig. 6 is a process drawing illustrating a method for producing the connection structure illustrated in Fig. 4 (a cross-sectional view in which the connection structure is cut along the thickness direction).
[Fig. 7] Fig. 7 is a cross sectional view for explaining a layered structure of a magnetoresistance effect element (a cross-sectional view in which the layered structure is cut along a thickness direction).
[Fig. 8] Fig. 8 is a circuit diagram of the magnetic sensor.
[Fig. 9] Fig. 9 is a perspective view of a magnetic encoder according to the present embodiment, which is different from Fig. 1.
[Fig. 10] Fig. 10 is a schematic diagram of a magnetic encoder according to the present embodiment, which is different from Fig. 1.
[Fig. 11] Fig. 11 is a plan view of a magnetic sensor constituting a magnetic encoder in the related art.

### Reference Signs List

- 7: antiferromagnetic layer
- 8: fixed magnetic layer
- 9: non-magnetic layer
- 10: free magnetic layer
- 11: protective layer
- 20: magnetic encoder
- 21: magnet
- 22: magnetic sensor
- 23: substrate
- 24a to 24h: magnetoresistance effect elements
- 40: lower-layer wiring
- 41: upper-layer wiring
- 42: insulating layer
- 43: bump unit
- 44: resist layer
- 50: phase-A first output terminal (Va1)
- 51: phase-A second output terminal (Va2)
- 52: input terminal (Vdd)
- 54: phase-B first output terminal (Vb1)
- 55: phase-B second output terminal (Vb2)
- 66: ground terminal (GND)
- 58, 60: differential amplifiers
- 89: rotating drum
- A to J: connection regions

## Claims

1. A magnetic sensor (22) that is arranged at a position apart from a magnetized face of a magnetic-field generating member (21) having the magnetized face on which N and S poles are alternately magnetized in a relative movement direction, the magnetic sensor (22) comprising multiple magnetoresistance effect elements (24a-24h) that are provided on a surface of a substrate (23) pairwise in the vertical direction and that utilize a magnetoresistance effect in which electric resistance values change in accordance with external magnetic fields,
wherein the magnetoresistance effect elements (24a-24h) are arranged in a matrix form in the relative movement direction and a vertical direction that is perpendicular to the relative movement direction on the surface of the substrate (23),
wherein wiring layers (40, 41) are configured using lower-layer wiring (40) and upper-layer wiring (41) that is formed on an insulating layer (42) covering the lower-layer wiring (40),
wherein the wiring layers (40, 41) are routed so as not to exist in spatial regions existing between the magnetoresistance effect elements (24a-24h) that are arranged in the vertical direction, and the multiple magnetoresistance effect elements (24a-24h) are bridge-connected using the wiring layers (40, 41); and
wherein each pair of neighbouring magnetoresistance effect elements (24a-24h) is included in a common bridge circuit.

2. The magnetic sensor (22) according to Claim 1, wherein the insulating layer (42) is provided with inclined regions (42a) in which a thickness of the insulating layer (42) gradually decreases as the insulating layer (42) extends toward connection regions (A-J) that are provided for connection of the upper-layer wiring (41) formed on the lower-layer wiring (40), the upper-layer wiring (41) is provided with end regions (41a) that are formed over an area extending from the inclined regions (42a) to the connection regions (A-J), and the upper-layer wiring (41) is electrically connected to the lower-layer wiring (40).

3. The magnetic sensor (22) according to Claim 1 or 2, wherein the lower-layer wiring (40) is provided at a height position at which the lower-layer wiring (40) opposes the magnetoresistance effect elements (24a-24h) in a plane parallel to the surface of the substrate (23), the lower-layer wiring (40) is routed in an area excluding the spatial regions existing between the magnetoresistance effect elements (24a-24h) which are arranged in the vertical direction so that the lower-layer wiring (40) does not exist in the spatial regions existing between the magnetoresistance effect elements (24a-24h) which are arranged in the vertical direction, and the upper-layer wiring (41) is electrically connected to the lower-layer wiring (40) via the insulating layer (42) covering the lower-layer wiring (40) and the magnetoresistance effect elements (24a24h).

4. The magnetic sensor (22) according to any one of Claims 1 to 3,
wherein all of an input terminal (52), a ground terminal (66), and output terminals (50, 51) that are electrically connected to the magnetoresistance effect elements (24a-24h) are arranged on the same end side along the vertical direction, and the individual terminals (50, 51, 52, 66) are arranged in the relative movement direction.

5. The magnetic sensor (22) according to any one of Claims 1 to 4,
wherein first to fourth magnetoresistance effect elements (24a, 24c, 24g, 24e) constitute a first bridge circuit, the first magnetoresistance effect element (24a) and the second magnetoresistance effect element (24c) are connected in series via a phase-A first output terminal Va1 (50), and the third magnetoresistance effect element (24g) and the fourth magnetoresistance effect element (24e) are connected in series via a phase-A second output terminal Va2 (51),
wherein the first magnetoresistance effect element (24a) and the third magnetoresistance effect element (24g) are connected to each other via an input terminal (52), and the second magnetoresistance effect element (24c) and the fourth magnetoresistance effect element (24e) are connected to each other via a ground terminal (66),
wherein the first magnetoresistance effect element (24a) and the second magnetoresistance effect element (24c), and the third magnetoresistance effect element (24g) and the fourth magnetoresistance effect element (24e) are individually arranged with predetermined center-to-center distances therebetween,
wherein the first magnetoresistance effect element (24a) and the fourth magnetoresistance effect element (24e), and the second magnetoresistance effect element (24c) and the third magnetoresistance effect element (24g) are provided side by side in the vertical direction perpendicular to the relative movement direction,
wherein fifth to eighth magnetoresistance effect elements (24b, 24d, 24h, 24f) constitute a second bridge circuit, the fifth magnetoresistance effect element (24b) and the sixth magnetoresistance effect element (24d) are connected in series via a phase-B first output terminal Vb1 (54), and the seventh magnetoresistance effect element (24h) and the eighth magnetoresistance effect element (24f) are connected in series via a phase-B second output terminal Vb2 (55),
wherein the fifth magnetoresistance effect element (24b) and the seventh magnetoresistance effect element (24h) are connected to each other via the input terminal (52), and the sixth magnetoresistance effect element (24d) and the eighth magnetoresistance effect element (24f) are connected to each other via the ground terminal (66),
wherein the fifth magnetoresistance (24b) effect element and the sixth magnetoresistance effect element (24d), and the seventh magnetoresistance effect element (24h) and the eighth magnetoresistance effect element (24f) are individually arranged with distances therebetween in the relative movement direction, and are arranged at positions that are shifted with respect to the first to fourth magnetoresistance effect elements (24a, 24c, 24g, 24e)
in the relative movement direction only by halves of the center-to-center distances between the individual magnetoresistance effect elements (24a, 24c, 24g, 24e) constituting the first bridge circuit,
wherein the fifth magnetoresistance effect element (24b) and the eighth magnetoresistance effect element (24f), and the sixth magnetoresistance effect element (24d) and the seventh magnetoresistance effect element (24f) are provided side by side in the vertical direction perpendicular to the relative movement direction,
a first set of elements including the first to fourth magnetoresistance effect elements (24a, 24c, 24g, 24e) and a second set of elements including the fifth to eighth magnetoresistance effect elements (24b, 24d, 24h, 24f) have substantially the same arrangement,
the first set of elements and the second set of elements are shifted with respect to each other in the moving direction, and the first bridge circuit and the second bridge circuit output a first waveform and a second waveform, respectively, wherein the first waveform is shifted from the second waveform.

6. A magnetic sensor (22) that is arranged at a position apart from a magnetized face of a magnetic-field generating member (21) having the magnetized face on which N and S poles are alternately magnetized in a relative movement direction, the magnetic sensor (22) comprising multiple resistance elements (24a-24h) including fixed resistance elements and magnetoresistance effect elements (24a-24h) that are provided on a surface of a substrate (23) pairwise in the vertical direction and wherein the magnetoresistance effect elements (24a-24h) utilize a magnetoresistance effect in which electric resistance values change in accordance with external magnetic fields,
wherein the resistance elements (24a-24h) are arranged in a matrix form in the relative movement direction and a vertical direction that is perpendicular to the relative movement direction on the surface of the substrate (23),
wherein wiring layers (40, 41) are configured using lower-layer wiring (40) and upper-layer wiring (41) that is formed on an insulating layer (42) covering the lower-layer wiring (40),
wherein the wiring layers (40, 41) are routed so as not to exist in spatial regions existing between the resistance elements (24a-24h) that are arranged in the vertical direction, and the multiple resistance elements (24a-24h) are bridge-connected using the wiring layers (40, 41); and
wherein each pair of neighbouring resistance elements (24a-24h) is included in a common bridge circuit
wherein first to fourth resistance elements (24a, 24c, 24g, 24e) constitute a first bridge circuit, the first resistance element (24a) and the second resistance element (24c) are connected in series via a phase-A first output terminal Va1 (50), and the third resistance element (24g) and the fourth resistance element (24e) are connected in series via a phase-A second output terminal Va2 (51),
wherein the first resistance element (24a) and the third resistance element (24g) are connected to each other via an input terminal (52), and the second resistance element (24c) and the fourth resistance element (24e) are connected to each other via a ground terminal (66),
wherein the first resistance element (24a) and the second resistance element (24c), and the third resistance element (24g) and the fourth resistance element (24e) are individually arranged with predetermined center-to-center distances therebetween,
wherein the first resistance element (24a) and the fourth resistance element (24e), and the second resistance element (24c) and the third resistance element (24g) are provided side by side in the vertical direction perpendicular to the relative movement direction,
wherein fifth to eighth resistance elements (24b, 24d, 24h, 24f) constitute a second bridge circuit, the fifth resistance element (24b) and the sixth resistance element (24d) are connected in series via a phase-B first output terminal Vb1 (54), and the seventh resistance element (24h) and the eighth resistance element (24f) are connected in series via a phase-B second output terminal Vb2 (55),
wherein the fifth resistance element (24b) and the seventh resistance element (24h) are connected to each other via the input terminal (52), and the sixth resistance element (24d) and the eighth resistance element (24f) are connected to each other via the ground terminal (66),
wherein the fifth resistance (24b) element and the sixth resistance element (24d), and the seventh resistance element (24h) and the eighth resistance element (24f) are individually arranged with distances therebetween in the relative movement direction, and are arranged at positions that are shifted with respect to the first to fourth resistance elements (24a, 24c, 24g, 24e) in the relative movement direction only by halves of the center-to-center distances between the individual resistance elements (24a, 24c, 24g, 24e) constituting the first bridge circuit,
wherein the fifth resistance element (24b) and the eighth resistance element (24f), and the sixth resistance element (24d) and the seventh resistance element (24f) are provided side by side in the vertical direction perpendicular to the relative movement direction,
wherein first set of elements including the first to fourth resistance elements (24a, 24c, 24g, 24e) and a second set of elements including the fifth to eighth resistance elements (24b, 24d, 24h, 24f) have substantially the same arrangement,
wherein fixed resistance elements are used as the second resistance element (24c), the third resistance element (24g), the sixth resistance element (24d), and the seventh resistance element (24h), and magnetoresistance effect elements are used as the first resistance element (24a), the fourth resistance element (24e), the fifth resistance element (24b), and the eighth resistance element (24f) and the fixed resistance elements (24c, 24d, 24g, 24h) are arranged in regions existing between the first resistance element (24a) and the fifth resistance element (24b) and between the fourth resistance element (24e) and the eighth resistance element (24f),
wherein the first set of elements and the second set of elements are shifted with respect to each other in the moving direction, and
the first bridge circuit and the second bridge circuit output a first waveform and a second waveform, respectively, wherein the first waveform is shifted from the second waveform.

7. A magnetic encoder (20) comprising a magnetic sensor (22) according to any one of Claims 1 to 6 and the magnetic-field generating member (21).

8. The magnetic encoder (20) according to Claim 7, wherein, when center-to-center distances between the N and S poles are set to λ, the resistance elements (24a-24h) that are connected in series as pairs are arranged with center-to-center distances of λ therebetween in the relative movement direction.

9. The magnetic encoder (20) according to Claim 7, wherein, when center-to-center distances between the N and S poles are set to λ, the resistance elements (24a-24h) that are connected in series as pairs are arranged with center-to-center distances of λ/2 therebetween in the relative movement direction.

10. The magnetic encoder (20) according to Claim 7 or 9, wherein, when center-to-center distances between the N and S poles are set to λ, the resistance elements (24a-24h) that are adjacent to each other in the relative movement direction are arranged with center-to-center distances of λ/4 therebetween.

## Patentansprüche

1. Ein Magnetsensor (22), der an einer Position in einem Abstand von einer magnetisierten Fläche eines magnetfelderzeugenden Elements (21) angeordnet ist, das die magnetisierte Fläche hat, auf der in Richtung einer relativen Bewegung abwechselnd N-Pole und S-Pole ausgebildet sind, wobei der Magnetsensor (22) mehrere Magnetwiderstandseffekt-Elemente (24a-24h) aufweist, die auf einer Fläche eines Substrats (23) paarweise in vertikaler Richtung angeordnet sind, und die einen Magnetwiderstandseffekt nutzen, bei dem sich elektrische Widerstandswerte entsprechend externen Magnetfeldern ändern,
wobei die Magnetwiderstandseffekt-Elemente (24a-24h) auf der Oberfläche des Substrats (23) in Form einer Matrix in der Richtung der relativen Bewegung und einer vertikalen Richtung, die rechtwinklig zur Richtung der relativen Bewegung ist, angeordnet sind,
wobei unter Benutzung einer Unterschichtverdrahtung (40) und einer Oberschichtverdrahtung (41), die auf einer isolierenden Schicht (43), welche die Unterschichtverdrahtung (40) bedeckt, ausgebildet ist, Verdrahtungsschichten (40, 41) eingerichtet sind,
wobei die Verdrahtungsschichten (40, 41) so verlegt sind, dass sie in räumlichen Regionen zwischen den Magnetwiderstandseffekt-Elementen (24a-24h), die in der vertikalen Richtung angeordnet sind, nicht vorhanden sind und dass die mehreren Magnetwiderstandseffekt-Elemente (24a-24h) unter Benutzung der Verdrahtungsschichten (40, 41) brückenmäßig miteinander verbunden sind; und
wobei jedes Paar benachbarter Magnetwiderstandseffekt-Elemente (24a-24h) in einer gemeinsamen Brückenschaltung enthalten ist.

2. Der Magnetsensor (22) nach Anspruch 1, wobei die isolierende Schicht (42) schräge Bereiche (42a) aufweist, in denen eine Dicke der isolierenden Schicht (42) entlang der Erstreckung der isolierenden Schicht (42) zu den Verbindungsbereichen (A-J), die zur Verbindung der Oberschichtverdrahtung (41), die auf der Unterschichtverdrahtung (40) ausgebildet ist, vorgesehen sind, allmählich abnimmt, wobei die Oberschichtverdrahtung (41) mit Endbereichen (41 a) ausgebildet ist, die über einem Bereich ausgebildet sind, der sich von den schrägen Bereichen (42a) zu den Verbindungsbereichen (A-J) erstreckt, und wobei die Oberschichtverdrahtung (41) elektrisch mit der Unterschichtverdrahtung (40) verbunden ist.

3. Der Magnetsensor (22) nach Anspruch 1 oder 2, wobei sich die Unterschichtverdrahtung (40) in einer Höhenposition befindet, in der die Unterschichtverdrahtung (40) den Magnetwiderstandseffekt-Elementen (24a-24h) in einer Ebene parallel zur Oberfläche des Substrats (23) gegenüberliegt, wobei die Unterschichtverdrahtung (40) in einem Bereich verlegt ist, der die räumlichen Bereiche, die zwischen den Magnetwiderstands-Elementen (24a-24h), die in der vertikalen Richtung angeordnet sind, ausnimmt, so dass in den räumlichen Bereichen, die zwischen den Magnetwiderstandseffekt-Elementen (24a-24h), die in der vertikalen Richtung angeordnet sind, keine Unterschichtverdrahtung (40) vorhanden ist, und wobei die Oberschichtverdrahtung (41) durch die isolierende Schicht (42), welche die Unterschichtverdrahtung (40) und die Magnetwiderstandseffekt-Elemente (24a-24h) bedeckt, mit der Unterschichtverdrahtung (40) verbunden ist.

4. Der Magnetsensor (22) nach einem der Ansprüche 1 bis 3, wobei ein Eingangsanschluss (52), ein Masseanschluss (66) und Ausgangsanschlüsse (50, 51), die elektrisch mit den Magnetwiderstandseffekt-Elementen (24a-24h) verbunden sind, alle entlang der vertikalen Richtung am gleichen Ende angeordnet sind, und wobei die einzelnen Anschlüsse (50, 51, 52, 66) in Richtung der relativen Bewegung angeordnet sind.

5. Der Magnetsensor (22) nach einem der Ansprüche 1 bis 4, wobei das erste bis vierte Magnetwiderstandseffekt-Element (24a, 24c, 24g, 24e) eine erste Brückenschaltung bilden, wobei das erste Magnetwiderstandseffekt-Element (24a) und das zweite Magnetwiderstandseffekt-Element (24c) durch einen ersten A-Phasen-Ausgangsanschluss Va1 (50) in Reihe miteinander verbunden sind, und wobei das dritte Magnetwiderstandseffekt-Element (24g) und das vierte Magnetwiderstandseffekt-Element (24e) durch einen zweiten A-Phasen-Ausgangsanschluss Va2 (51) miteinander verbunden sind,
wobei das erste Magnetwiderstandseffekt-Element (24a) und das dritte Magnetwiderstandseffekt-Element (24g) durch einen Eingangsanschluss (52) miteinander verbunden sind, und wobei das zweite Magnetwiderstandseffekt-Element (24c) und der vierte Magnetwiderstandseffekt-Element (24e) durch einen Masseanschluss (66) miteinander verbunden sind,
wobei das erste Magnetwiderstandseffekt-Element (24a) und das zweite Magnetwiderstandseffekt-Element (24c) sowie das dritte Magnetwiderstandseffekt-Element (24g) und das vierte Magnetwiderstandseffekt-Element (24e) einzeln mit vorgegebenen Zentrum-zu-Zentrum-Abständen zwischen ihnen angeordnet sind,
wobei das erste Magnetwiderstandseffekt-Element (24a) und das vierte Magnetwiderstandseffekt-Element (24e) sowie das zweite Magnetwiderstandseffekt-Element (24c) und das dritte Magnetwiderstandseffekt-Element (24g) in der vertikalen Richtung, die rechtwinklig zur Richtung der relativen Bewegung ist, nebeneinander angeordnet sind,
wobei das fünfte bis achte Magnetwiderstandseffekt-Element (24b, 24d, 24h, 24f) eine zweite Brückenschaltung bilden, wobei das fünfte Magnetwiderstandseffekt-Element (24b) und das sechste Magnetwiderstandseffekt-Element (24d) durch einen ersten B-Phasen-Ausgangsanschluss Vb1 (54) in Reihe verbunden sind, und wobei das siebte Magnetwiderstandseffekt-Element (24h) und das achte Magnetwiderstandseffekt-Element (24f) durch einen zweiten B-Phasen-Ausgangsanschluss Vb2 (55) in Reihe verbunden sind,
wobei das fünfte Magnetwiderstandseffekt-Element (24b) und das sechste Magnetwiderstandseffekt-Element (24d) sowie das siebte Magnetwiderstandseffekt-Element (24h) und das achte Magnetwiderstandseffekt-Element (24f) einzeln mit Abständen zwischen ihnen in Richtung der relativen Bewegung an Positionen angeordnet sind, die in Bezug auf das erste bis vierte Magnetwiderstandseffekt-Element (24a, 24c, 24g, 24e) in Richtung der relativen Bewegung nur um die Hälfte der Zentrum-zu-Zentrum-Abstände zwischen den einzelnen Magnetwiderstandseffekt-Elementen (24a, 24c, 24g, 24e), welche die erste Brückenschaltung bilden, verschoben sind,
wobei das fünfte Magnetwiderstandseffekt-Element (24b) und das achte Magnetwiderstandseffekt-Element (24f) sowie das sechste Magnetwiderstandseffekt-Element (24d) und das siebte Magnetwiderstandseffekt-Element (24f) in der vertikalen Richtung rechtwinklig zur Richtung der relativen Bewegung nebeneinander angeordnet sind,
wobei ein erster Satz an Elementen, der das erste bis vierte Magnetwiderstandseffekt-Element (24a, 24c, 24g, 24e) enthält, und ein zweiter Satz an Elementen, der das fünfte bis achte Magnetwiderstandseffekt-Element (24b, 24d, 24h, 24f) enthält, im Wesentlichen die gleiche Anordnung haben,
wobei der erste Satz an Elementen und der zweite Satz an Elementen in der Bewegungsrichtung gegeneinander verschoben sind, und
wobei die erste Brückenschaltung und die zweite Brückenschaltung jeweils eine erste Wellenform bzw. eine zweite Wellenform ausgeben, wobei die erste Wellenform gegenüber der zweiten Wellenform verschoben ist.

6. Ein Magnetsensor (22), der an einer Position angeordnet ist, die von einer magnetisierten Fläche eines magnetfelderzeugenden Elements (21) beabstandet ist, das die magnetisierte Fläche hat, auf der in Richtung einer relativen Bewegung abwechselnd N-Pole und S-Pole magnetisiert sind, wobei der Magnetsensor (22) mehrere Widerstandselemente (24a-24h) einschließlich Festwiderstandselementen und Magnetwiderstandseffekt-Elementen (24a-24h) aufweist, die auf einer Fläche eines Substrats (23) in vertikaler Richtung paarweise angeordnet sind, und wobei die Magnetwiderstandseffekt-Elemente (24a-24h) einen Magnetwiderstandseffekt nutzen, bei dem sich elektrische Widerstandswerte entsprechend äußeren Magnetfeldern ändern,
wobei die Widerstandselemente (24a-24h) auf der Oberfläche des Substrats (23) in Form einer Matrix in Richtung der relativen Bewegung und einer vertikalen Richtung, die rechtwinklig zur Richtung der relativen Bewegung ist, ausgebildet sind,
wobei unter Benutzung einer Unterschichtverdrahtung (40) und einer Oberschichtverdrahtung (41), die auf einer isolierenden Schicht (43), welche die Unterschichtverdrahtung (40) bedeckt, ausgebildet ist, Verdrahtungsschichten (40, 41) eingerichtet sind,
wobei die Verdrahtungsschichten (40, 41) so verlegt sind, dass sie in räumlichen Bereichen, die zwischen den Widerstandselementen (24a-24h), die in der vertikalen Richtung angeordnet sind, nicht vorhanden sind, und die mehreren Widerstandselemente (24a-24h) unter Benutzung der Verdrahtungsschichten (40, 41) als Brückenschaltung miteinander verbunden sind; und wobei jedes Paar benachbarter Widerstandselemente (24a-24h) in einer gemeinsamen Brückenschaltung enthalten ist,
wobei das erste bis vierte Widerstandselement (24a, 24c, 24g, 24e) eine erste Brückenschaltung bilden, wobei das erste Widerstandselement (24a) und das zweite Widerstandselement (24c) durch einen ersten A-Phasen-Ausgangsanschluss Va1 (50) in Reihe verbunden sind, und wobei das dritte Widerstandselement (24g) und das vierte Widerstandselement (24e) durch einen zweiten A-Phasen-Ausgangsanschluss Va2 (51) in Reihe verbunden sind,
wobei das erste Widerstandselement (24a) und das dritte Widerstandselement (24g) durch einen Eingangsanschluss (52) miteinander verbunden sind, und wobei das zweite Widerstandselement (24c) und das vierte Widerstandselement (24e) durch einen Masseanschluss (66) miteinander verbunden sind,
wobei das erste Widerstandselement (24a) und das zweite Widerstandselement (24c) sowie das dritte Widerstandselement (24g) und das vierte Widerstandselement (24e) einzeln mit vorgegebenen Zentrum-zu-Zentrum-Abständen zwischen ihnen angeordnet sind,
wobei das erste Widerstandselement (24a) und das vierte Widerstandselement (24e) sowie das zweite Widerstandselement (24c) und das dritte Widerstandselement (24g) in der vertikalen Richtung, die rechtwinklig zur Richtung der relativen Bewegung ist, nebeneinander angeordnet sind,
wobei das fünfte bis achte Widerstandselement (24b, 24d, 24h, 24f) eine zweite Brückenschaltung bilden, wobei das fünfte Widerstandselement (24b) und das sechste Widerstandselement (24d) durch einen ersten B-Phasen-Ausgangsanschluss Vb1 (54) in Reihe verbunden sind, und wobei das zweite Widerstandselement (24h) und das achte Widerstandselement (24f) durch einen zweiten B-Phasen-Ausgangsanschluss Vb2 (55) in Reihe verbunden sind,
wobei das fünfte Widerstandselement (24b) und das siebte Widerstandselement (24h) durch den Eingangsanschluss (52) miteinander verbunden sind, und wobei das sechste Widerstandselement (24d) und das achte Widerstandselement (24f) durch den Masseanschluss (66) miteinander verbunden sind,
wobei das fünfte Widerstandselement (24b) und das sechste Widerstandselement (24d) sowie das siebte Widerstandselement (24h) und das achte Widerstandselement (24f) einzeln mit Abständen in Richtung der relativen Bewegung zwischen ihnen und an Positionen angeordnet sind, die gegenüber dem ersten bis vierten Widerstandselement (24a, 24c, 24g, 24e) in Richtung der relativen Bewegung nur um die Hälfte der Zentrum-zu-Zentrum-Abstände zwischen einzelnen Widerstandselementen (24a, 24c, 24g, 24e), welche die erste Brückenschaltung bilden, verschoben sind,
wobei das fünfte Widerstandselement (24b) und das achte Widerstandselement (24f) sowie das sechste Widerstandselement (24d) und das siebte Widerstandselement (24h) in der vertikalen Richtung, die rechtwinklig zur Richtung der relativen Bewegung ist, nebeneinander angeordnet sind,
wobei der erste Satz an Elementen, der das erste bis vierte Widerstandselement (24a, 24c, 24g, 24e) enthält, und der zweite Satz an Elementen, der das fünfte bis achte Widerstandselement (24b, 24d, 24h, 24f) enthält, im Wesentlichen die gleiche Anordnung haben,
wobei Festwiderstandselemente als das zweite Widerstandselement (24c), das dritte Widerstandselement (24g), das sechste Widerstandselement (24d) und das siebte Widerstandselement (24h) verwendet werden, und wobei Magnetwiderstandseffekt-Elemente als das erste Widerstandselement (24a), das vierte Widerstandselement (24e), das fünfte Widerstandselement (24b) und das achte Widerstandselement (24f) benutzt werden, und wobei die Festwiderstandselemente (24c, 24d, 24g, 24h) in Bereichen angeordnet sind, die sich zwischen dem ersten Widerstandselement (24a) und dem fünften Widerstandselement (24b) sowie zwischen dem vierten Widerstandselement (24e) und dem achten Widerstandselement (24f) befinden,
wobei der erste Satz an Elementen und der zweite Satz an Elementen entlang der Bewegungsrichtung gegeneinander verschoben sind, und
wobei die erste Brückenschaltung und die zweite Brückenschaltung jeweils eine Wellenform ausgeben, wobei die erste Wellenform gegenüber der zweiten Wellenform verschoben ist.

7. Ein Magnetcodierer (20), der einen Magnetsensor (22) nach einem der Ansprüche 1 bis 6 und das magnetfelderzeugende Element (21) aufweist.

8. Der Magnetcodierer (20) nach Anspruch 7, wobei, wenn der Zentrum-zu-Zentrum-Abstand zwischen den N-Polen und den S-Polen auf λ festgelegt ist, wobei die Widerstandselemente (24a-24h), die als Paare in Reihe verbunden sind, in Richtung der relativen Bewegung mit Zentrum-zu-Zentrum-Abständen von λ zwischen ihnen angeordnet sind.

9. Der Magnetcodierer (20) nach Anspruch 7, wobei, wenn die Zentrum-zu-Zentrum-Abstände zwischen den N-Polen und den S-Polen auf λ festgelegt sind, wobei die Widerstandselemente (24a-24h), die als Paare in Reihe verbunden sind, in Richtung der relativen Bewegung mit Zentrum-zu-Zentrum-Abständen von λ/2 zwischen ihnen angeordnet sind.

10. Der Magnetcodierer (20) nach einem der Ansprüche 7 oder 9, wobei, wenn die Zentrum-zu-Zentrum-Abstände zwischen den N-Polen und den S-Polen auf A festgelegt sind, wobei die Widerstandselemente (24a-24h), die in Richtung der relativen Bewegung einander benachbart sind, mit Zentrum-zu-Zentrum-Abständen von λ/4 zwischen ihnen angeordnet sind.

## Revendications

1. Capteur magnétique (22) placé en une position distante d'une face magnétisée d'un élément générant un champ magnétique (21) ayant la face magnétisée sur laquelle des pôles N et S sont alternativement magnétisés dans une direction de mouvement relatif, le capteur magnétique (22) comprenant des éléments à effet de magnétorésistance multiples (24a-24h) qui sont placés sur une surface d'un substrat (23) par paires dans la direction verticale et qui utilisent un effet de magnétorésistance dans lequel les valeurs de résistance électrique changent en fonction de champs magnétiques externes,
dans lequel les éléments à effet de magnétorésistance (24a-24h) sont agencés sous forme de matrice dans la direction de mouvement relatif et dans une direction verticale qui est perpendiculaire à la direction de mouvement relatif sur la surface du substrat (23),
dans lequel des couches de câblage (40, 41) sont configurées en utilisant un câblage de couche inférieure (40) et un câblage de couche supérieure (41) qui est formé sur une couche isolante (42) qui couvre le câblage de couche inférieure (40),
dans lequel les couches de câblage (40, 41) ont un cheminement tel qu'elles n'existent pas dans les régions spatiales qui existent entre les éléments à effet de magnétorésistance (24a-24h) qui sont agencés dans la direction verticale, et les éléments à effet de magnétorésistance multiples (24a-24h) sont montés en pont en utilisant les couches de câblage (40, 41) ; et
dans lequel chaque paire d'éléments à effet de magnétorésistance voisins (24a-24h) est comprise dans un circuit de pont commun.

2. Capteur magnétique (22) selon la revendication 1, dans lequel la couche isolante (42) est pourvue de régions inclinées (42a) dans lesquelles une épaisseur de la couche isolante (42) diminue progressivement lorsque la couche isolante (42) s'étend vers des régions de connexion (A-J) qui sont prévues pour la connexion du câblage de couche supérieure (41) formé sur le câblage de couche inférieure (40), le câblage de couche supérieure (41) est pourvu de régions d'extrémité (41a) qui sont formées sur une zone qui va des régions inclinées (42a) aux régions de connexion (A-J), et le câblage de couche supérieure (41) est connecté électriquement au câblage de couche inférieure (40).

3. Capteur magnétique (22) selon la revendication 1 ou 2, dans lequel le câblage de couche inférieure (40) est placé à une position de hauteur à laquelle le câblage de couche inférieure (40) se trouve en face des éléments à effet de magnétorésistance (24a-24h) dans un plan parallèle à la surface du substrat (23), le câblage de couche inférieure (40) chemine dans une zone qui exclue les régions spatiales qui existent entre les éléments à effet de magnétorésistance (24a-24h) qui sont agencés dans la direction verticale, de sorte que le câblage de couche inférieure (40) n'existe pas dans les régions spatiales qui existent entre les éléments à effet de magnétorésistance (24a-24h) qui sont agencés dans la direction verticale, et le câblage de couche supérieure (41) est connecté électriquement au câblage de couche inférieure (40) via la couche isolante (42) qui couvre le câblage de couche inférieure (40) et les éléments à effet de magnétorésistance (24a-24h).

4. Capteur magnétique (22) selon l'une quelconque des revendications 1 à 3, dans lequel une borne d'entrée (52), une borne de masse (66) et des bornes de sortie (50, 51) qui sont connectées électriquement aux éléments à effet de magnétorésistance (24a-24h) sont toutes placées du côté de la même extrémité le long de la direction verticale, et les bornes individuelles (50, 51, 52, 66) sont agencées dans la direction de mouvement relatif.

5. Capteur magnétique (22) selon l'une quelconque des revendications 1 à 4,
dans lequel des premier, deuxième, troisième et quatrième éléments à effet de magnétorésistance (24a, 24c, 24g, 24e) constituent un premier circuit en pont, le premier élément à effet de magnétorésistance (24a) et le deuxième élément à effet de magnétorésistance (24c) sont connectés en série via une première borne de sortie de phase A Va1 (50), et le troisième élément à effet de magnétorésistance (24g) et le quatrième élément à effet de magnétorésistance (24e) sont connectés en série via une deuxième borne de sortie de phase A Va2 (51),
dans lequel le premier élément à effet de magnétorésistance (24a) et le troisième élément à effet de magnétorésistance (24g) sont connectés l'un à l'autre via une borne d'entrée (52), et le deuxième élément à effet de magnétorésistance (24c) et le quatrième élément à effet de magnétorésistance (24e) sont connectés l'un à l'autre via une borne de masse (66),
dans lequel le premier élément à effet de magnétorésistance (24a) et le deuxième élément à effet de magnétorésistance (24c), et le troisième élément à effet de magnétorésistance (24g) et le quatrième élément à effet de magnétorésistance (24e) sont placés individuellement avec des distances de centre à centre entre eux,
dans lequel le premier élément à effet de magnétorésistance (24a) et le quatrième élément à effet de magnétorésistance (24e), et le deuxième élément à effet de magnétorésistance (24c) et le troisième élément à effet de magnétorésistance (24g) sont placés côte à côte dans la direction verticale, perpendiculairement à la direction de mouvement relatif,
dans lequel des cinquième, sixième, septième et huitième éléments à effet de magnétorésistance (24b, 24d, 24h, 24f) constituent un deuxième circuit en pont, le cinquième élément à effet de magnétorésistance (24b) et le sixième élément à effet de magnétorésistance (24d) sont connectés en série via une première borne de sortie de phase B Vb1 (54), et le septième élément à effet de magnétorésistance (24h) et le huitième élément à effet de magnétorésistance (24f) sont connectés en série via une deuxième borne de sortie de phase B Vb2 (55),
dans lequel le cinquième élément à effet de magnétorésistance (24b) et le septième élément à effet de magnétorésistance (24h) sont connectés l'un à l'autre via la borne d'entrée (52), et le sixième élément à effet de magnétorésistance (24d) et le huitième élément à effet de magnétorésistance (24f) sont connectés l'un à l'autre via la borne de masse (66),
dans lequel le cinquième élément à effet de magnétorésistance (24b) et le sixième élément à effet de magnétorésistance (24d), et le septième élément à effet de magnétorésistance (24h) et le huitième élément à effet de magnétorésistance (24f) sont placés individuellement avec des distances entre eux dans la direction de mouvement relatif, et sont placés en des positions qui sont décalées par rapport aux quatre premiers éléments à effet de magnétorésistance (24a, 24c, 24g, 24e) dans la direction de mouvement relatif seulement de la moitié des distances de centre à centre entre les éléments à effet de magnétorésistance individuels (24a, 24c, 24g, 24e) qui constituent le premier circuit en pont,
dans lequel le cinquième élément à effet de magnétorésistance (24b) et le huitième élément à effet de magnétorésistance (24f), et le sixième élément à effet de magnétorésistance (24d) et le septième élément à effet de magnétorésistance (24f) sont placés côte à côte dans la direction verticale, perpendiculairement à la direction de mouvement relatif,
un premier ensemble d'éléments comprenant les quatre premiers éléments à effet de magnétorésistance (24a, 25c, 24g, 24e) et un deuxième ensemble d'éléments comprenant les quatre derniers éléments à effet de magnétorésistance (24b, 25d, 24h, 24f) ont substantiellement le même agencement,
le premier ensemble d'éléments et le deuxième ensemble d'éléments sont décalés l'un par rapport à l'autre dans la direction de mouvement, et
le premier circuit en pont et le deuxième circuit en pont délivrent en sortie respectivement une première forme d'onde et une deuxième forme d'onde, la première forme d'onde étant décalée par rapport à la deuxième forme d'onde.

6. Capteur magnétique (22) placé en une position distante d'une face magnétisée d'un élément générant un champ magnétique (21) ayant la face magnétisée sur laquelle des pôles N et S sont alternativement magnétisés dans une direction de mouvement relatif, le capteur magnétique (22) comprenant des éléments de résistance multiples (24a-24h) comportant des éléments à résistance fixe et des éléments à effet de magnétorésistance (24a-24h) qui sont placés sur une surface d'un substrat (23) par paires dans la direction verticale et dans lequel les éléments à effet de magnétorésistance (24a-24h) utilisent un effet de magnétorésistance dans lequel les valeurs de résistance électrique changent en fonction de champs magnétiques externes,
dans lequel les éléments de résistance (24a-24h) sont agencés sous forme de matrice dans la direction de mouvement relatif et dans une direction verticale qui est perpendiculaire à la direction de mouvement relatif sur la surface du substrat (23),
dans lequel des couches de câblage (40, 41) sont configurées en utilisant un câblage de couche inférieure (40) et un câblage de couche supérieure (41) qui est formé sur une couche isolante (42) qui couvre le câblage de couche inférieure (40),
dans lequel les couches de câblage (40, 41) ont un cheminement tel qu'elles n'existent pas dans les régions spatiales qui existent entre les éléments de résistance (24a-24h) qui sont agencés dans la direction verticale, et les éléments de résistance multiples (24a-24h) sont montés en pont en utilisant les couches de câblage (40, 41); et
dans lequel chaque paire d'éléments de résistance voisins (24a-24h) est comprise dans un circuit de pont commun ;
dans lequel des premier, deuxième, troisième et quatrième éléments de résistance (24a, 24c, 24g, 24e) constituent un premier circuit en pont, le premier élément de résistance (24a) et le deuxième élément de résistance (24c) sont connectés en série via une première borne de sortie de phase A Va1 (50), et le troisième élément de résistance (24g) et le quatrième élément de résistance (24e) sont connectés en série via une deuxième borne de sortie de phase A Va2 (51),
dans lequel le premier élément de résistance (24a) et le troisième élément de résistance (24g) sont connectés l'un à l'autre via une borne d'entrée (52), et le deuxième élément de résistance (24c) et le quatrième élément de résistance (24e) sont connectés l'un à l'autre via une borne de masse (66),
dans lequel le premier élément de résistance (24a) et le deuxième élément de résistance (24c), et le troisième élément de résistance (24g) et le quatrième élément de résistance (24e) sont placés individuellement avec des distances de centre à centre prédéterminées entre eux,
dans lequel le premier élément de résistance (24a) et le quatrième élément de résistance (24e), et le deuxième élément de résistance (24c) et le troisième élément de résistance (24g) sont placés côte à côte dans la direction verticale, perpendiculairement à la direction de mouvement relatif,
dans lequel des cinquième, sixième, septième et huitième éléments de résistance (24b, 24d, 24h, 24f) constituent un deuxième circuit en pont, le cinquième élément de résistance (24b) et le sixième élément de résistance (24d) sont connectés en série via une première borne de sortie de phase B Vb1 (54), et le septième élément de résistance (24h) et le huitième élément de résistance (24f) sont connectés en série via une deuxième borne de sortie de phase B Vb2 (55),
dans lequel le cinquième élément de résistance (24b) et le septième élément de résistance (24h) sont connectés l'un à l'autre via la borne d'entrée (52), et le sixième élément de résistance (24d) et le huitième élément de résistance (24f) sont connectés l'un à l'autre via la borne de masse (66),
dans lequel le cinquième élément de résistance (24b) et le sixième élément de résistance (24d), et le septième élément de résistance (24h) et le huitième élément de résistance (24f) sont placés individuellement avec des distances entre eux dans la direction de mouvement relatif, et sont placés en des positions qui sont décalées par rapport aux quatre premiers éléments de résistance (24a, 24c, 24g, 24e) dans la direction de mouvement relatif seulement de la moitié des distances de centre à centre entre les éléments de résistance individuels (24a, 24c, 24g, 24e) qui constituent le premier circuit en pont,
dans lequel le cinquième élément de résistance (24b) et le huitième élément de résistance (24f), et le sixième élément de résistance (24d) et le septième élément de résistance (24f) sont placés côte à côte dans la direction verticale, perpendiculairement à la direction de mouvement relatif,
dans lequel un premier ensemble d'éléments comprenant les quatre premiers éléments de résistance (24a, 25c, 24g, 24e) et un deuxième ensemble d'éléments comprenant les quatre derniers éléments de résistance (24b, 25d, 24h, 24f) ont substantiellement le même agencement,
dans lequel des éléments à résistance fixe sont utilisés en tant que deuxième élément de résistance (24c), troisième élément de résistance (24g), sixième élément de résistance (24d) et septième élément de résistance (24h), et des éléments à effet de magnétorésistance sont utilisés en tant que premier élément de résistance (24a), quatrième élément de résistance (24e), cinquième élément de résistance (24b) et huitième élément de résistance (24f), et les éléments à résistance fixe (24c, 24d, 24g, 24h) sont placés dans des régions qui existent entre le premier élément de résistance (24a) et le cinquième élément de résistance (24b) et entre le quatrième élément de résistance (24e) et le huitième élément de résistance (24f),
dans lequel le premier ensemble d'éléments et le deuxième ensemble d'éléments sont décalés l'un par rapport à l'autre dans la direction de mouvement, et
le premier circuit en pont et le deuxième circuit en pont délivrent en sortie respectivement une première forme d'onde et une deuxième forme d'onde, la première forme d'onde étant décalée par rapport à la deuxième forme d'onde.

7. Codeur magnétique (20) comprenant un capteur magnétique (22) selon l'une quelconque des revendications 1 à 6 et l'élément générant un champ magnétique (21).

8. Codeur magnétique (20) selon la revendication 7, dans lequel, quand les distances de centre à centre entre les pôles N et S valent λ, les éléments de résistance (24a-24h) qui sont connectés en série par paires sont agencés avec des distances de centre à centre égales à λ entre eux dans la direction de mouvement relatif.

9. Codeur magnétique (20) selon la revendication 7, dans lequel, quand les distances de centre à centre entre les pôles N et S valent λ, les éléments de résistance (24a-24h) qui sont connectés en série par paires sont agencés avec des distances de centre à centre égales à λ/2 entre eux dans la direction de mouvement relatif.

10. Codeur magnétique (20) selon la revendication 7 ou 9, dans lequel, quand les distances de centre à centre entre les pôles N et S valent λ, les éléments de résistance (24a-24h) qui sont adjacents entre eux dans la direction de mouvement relatif sont agencés avec des distances de centre à centre égales à λ/4 entre eux.
